Europäisches Patentamt

European Patent Office

Office européen des brevets

(19)

(11) **EP 0 766 398 A1**

(12) **EUROPÄISCHE PATENTANMELDUNG**

(43) Veröffentlichungstag:
02.04.1997 Patentblatt 1997/14

(51) Int. Cl.$^6$: **H03K 17/955**

(21) Anmeldenummer: 96115296.4

(22) Anmeldetag: 24.09.1996

(84) Benannte Vertragsstaaten:
**DE FR GB IT**

(30) Priorität: 28.09.1995 DE 19536198

(71) Anmelder: **Endress + Hauser GmbH + Co.**
**79689 Maulburg (DE)**

(72) Erfinder: **Wetzel, Gustav**
**79539 Lörrach (DE)**

(74) Vertreter: **Leiser, Gottfried, Dipl.-Ing.**
**Prinz & Partner,**
**Manzingerweg 7**
**81241 München (DE)**

(54) **Kapazitiver Schalter**

(57)     Der kapazitive Annäherungs- oder Grenzschalter hat eine kapazitive Sonde mit einer Sensorelektrode (11) und einer Schirmelektrode (12). Die Sensorelektrode ist mit einem Oszillator verbunden, der durch ein rückgekoppeltes System von zwei Operationsverstärkern (16,15) gebildet ist, von denen ein Operationsverstärker (15) als Differenzverstärker und der andere Operationsverstärker (16) als Spannungsfolger geschaltet ist. Die Sensorelektrode ist mit dem invertierenden Eingang des Differenzverstärkers (15) verbunden, in dessen Rückkopplungskreis ein Kondensator (18) liegt, wodurch die Wechselspannungsverstärkung bestimmt ist. Ein einstellbarer Teil des Ausgangsspannung des Differenzverstärkers (15) wird dem nichtinvertierenden Eingang des Spannungsfolgers (16) zugeführt, dessen Ausgang mit dem nichtinvertierenden Eingang des Differenzverstärkers (15) verbunden ist, an den die Schirmelektrode (12) angeschlossen ist. Dadurch wird der Schwingungseinsatz und der Schwingungsabriß des Oszillators durch Änderungen der Kapazität der Sensorelektrode (11) bestimmt, und die Schirmelektrode (12) wird stets genau auf dem gleichen Wechselspannungspotential wie die Sensorelektrode (11) gehalten.

EP 0 766 398 A1

## Beschreibung

Die Erfindung betrifft einen kapazitiven Schalter mit einer kapazitiven Sonde, die eine Sensorelektrode und eine Schirmelektrode aufweist, und mit einer Elektronik, die einen durch ein rückgekoppeltes System von zwei Verstärkern gebildeten Oszillator enthält, wobei die Sensorelektrode mit einem der Verstärker so verbunden ist, daß der Schwingungseinsatz und der Schwingungsabriß des Oszillators durch Änderungen der Kapazität der Sensorelektrode bestimmt wird, und wobei die Schirmelektrode an einen Verstärkerausgang derart angeschlossen ist, daß die an der Schirmelektrode anliegende Wechselspannung nach Amplitude und Phase mit der an der Sensorelektrode anliegenden Wechselspannung übereinstimmt.

Kapazitive Schalter dieser Art werden beispielsweise als Annäherungsschalter verwendet, oder als Grenzschalter zur Überwachung eines vorbestimmten Füllstands in einem Behälter. Bei einem Annäherungsschalter wird die den Schwingungseinsatz und den Schwingungsabriß bestimmende Kapazität der Sensorelektrode durch ein Objekt beeinflußt, das sich der kapazitiven Sonde nähert. Bei einem kapazitiven Füllstandsgrenzschalter hängt die Kapazität der Sensorelektrode davon ab, ob die Sonde von dem Füllgut im Behälter bedeckt ist oder nicht. Der Oszillator wird so eingestellt, daß er nicht schwingt, wenn sich kein Objekt in der Nähe der Sonde befindet bzw. wenn die Sonde nicht von dem Füllgut bedeckt ist, und daß die Schwingung einsetzt, wenn die Kapazität der Sensorelektrode infolge der Annäherung eines Objekts oder der Bedeckung mit Füllgut über einen bestimmten Wert ansteigt, und daß die Schwingung abreißt, wenn die Kapazität der Sensorelektrode wieder unter einen bestimmten Wert fällt. Der Schwingungseinsatz oder Schwingungsabriß wird von einer Auswerteschaltung festgestellt und zur Auslösung von Anzeige- oder Schaltvorgängen benutzt.

Die Schirmelektrode, die stets auf dem gleichen Wechselspannungspotential wie die Sensorelektrode gehalten wird, verhindert, daß sich Störeinflüsse, wie Verschmutzungen und Ansatzbildungen, auf die Kapazität der Sensorelektrode und damit auf den Schwingungseinsatz oder den Schwingungsabriß des Oszillators auswirken.

Bei einem aus der DE 27 44 785 B2 bekannten kapazitiven Schalter dieser Art sind die beiden Verstärker, die den Oszillator bilden, einfache Transistorstufen, wobei die Sensorelektrode mit der Basis des Transistors der ersten Transistorstufe verbunden ist. Zur Gewinnung der Spannung, die an die Schirmelektrode angelegt wird, ist eine dritte Transistorstufe hinzugefügt, die als Emitterfolger ausgebildet und so an den Oszillator angeschlossen ist, daß sie an ihrem niederohmigen Emitterausgang eine Wechselspannung liefert, die im wesentlichen die gleiche Phase und die gleiche Amplitude wie die an der Sensorelektrode anliegende Wechselspannung hat. An diesen niederohmigen Emitterausgang ist die Schirmelektrode angeschlossen.

Aufgabe der Erfindung ist die Schaffung eines kapazitiven Schalters, der für sehr kleine Kapazitätsänderungen empfindlich ist, dessen Ansprechpunkt sehr genau einstellbar ist und bei dem die Schirmelektrode unmittelbar an einen niederohmigen Ausgang des Oszillators angeschlossen werden kann.

Nach der Erfindung wird diese Aufgabe dadurch gelöst, daß der Oszillator durch zwei Operationsverstärker gebildet ist, daß der erste Operationsverstärker als Differenzverstärker geschaltet ist, dessen invertierender Eingang mit der Sensorelektrode verbunden ist und dessen vom Ausgang zum invertierenden Eingang führender Rückkopplungskreis einen Kondensator parallel zu einem hochohmigen Widerstand enthält, daß der zweite Operationsverstärker als Spannungfolger geschaltet ist und an seinem nichtinvertierenden Eingang einen mittels eines einstellbaren Spannungsteilers eingestellten Teil der Ausgangsspannung des ersten Operationsverstärkers empfängt, daß der Ausgang des zweiten Operationsverstärkers mit dem nichtinvertierenden Eingang des ersten Operationsverstärkers verbunden ist, und daß die Schirmelektrode an die Verbindung zwischen dem Ausgang des zweiten Operationsverstärkers und dem nichtinvertierenden Eingang des ersten Operationsverstärkers angeschlossen ist.

Bei dem erfindungsgemäßen kapazitiven Schalter ist die Schirmelektrode an den nichtinvertierenden Eingang eines Operationsverstärkers angeschlossen, an dessen invertierenden Eingang die Sensorelektrode angeschlossen ist. Da ein Operationsverstärker seine beiden Eingänge stets auf dem gleichen Potential zu halten sucht, ist gewährleistet, daß die an der Schirmelektrode anliegende Wechselspannung nach Amplitude und Phase genau mit der Wechselspannung übereinstimmt, die an der Sensorelektrode anliegt. Da zudem der Ausgang des als Spannungsfolger geschalteten zweiten Operationsverstärkers, der die Wechselspannung zu der Schirmelektrode liefert, sehr niederohmig ist, bildet er einen idealen Treiber für die Schirmelektrode, wodurch eine exzellente Schirmwirkung erzielt wird. Zugleich ergibt die Bildung des Oszillators aus zwei Operationsverstärkern einen sehr empfindlichen kapazitiven Schalter, der sehr geringe Änderungen der Sensorkapazität, die in der Größenordnung von wenigen Zehntel Picofarad liegen können, auswerten kann. Trotz dieser hohen Empfindlichkeit zeigt der kapazitive Schalter wegen der guten Schirmwirkung eine extrem geringe Beeinträchtigung durch Verschmutzungen, Ansatzbildungen oder ähnliche Störeinflüsse.

Ferner hat der kapazitive Schalter nach der Erfindung eine sehr gute Temperaturstabilität, da diese im wesentlichen nur von der Stabilität der Kapazitäten des Kondensators im Rückkopplungskreis sowie der Sensorelektrode und der Stabilität des Teilerfaktors des Spannungsteilers abhängt.

Eine vorteilhafte Ausgestaltung des kapazitiven Schalters nach der Erfindung besteht darin, daß an den Ausgang des Oszillators eine Auswerteschaltung angeschlossen ist, die ein Ausgangssignal liefert, das einen ersten Signalwert hat, wenn der Oszillator nicht schwingt, und das einen zweiten Signalwert hat, wenn der Oszillator schwingt.

Ein weiterer Vorteil des kapazitiven Schalters nach der Erfindung besteht darin, daß ihm auf einfache Weise eine Schalthysterese erteilt werden kann. Dies geschieht nach einer Weiterbildung der Erfindung dadurch, daß der Spannungsteiler einen Widerstand enthält, dem ein Schalter parallelgeschaltet ist, der durch das Ausgangssignal der Auswerteschaltung so gesteuert wird, daß er den Widerstand kurzschließt, wenn der Oszillator nicht schwingt, um durch Verringerung des Teilerfaktors des Spannungsteilers eine Schalthysterese zu erzeugen, wenn der Oszillator schwingt.

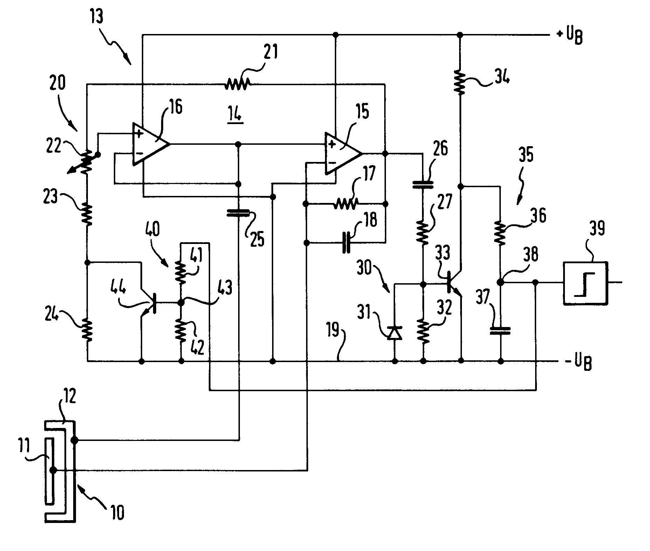

Weitere Merkmale und Vorteile ergeben sich aus der folgenden Beschreibung eines Ausführungsbeispiels, dessen Schaltbild in der einzigen Figur der Zeichnung dargestellt ist.

Die Zeichnung zeigt schematisch eine kapazitive Sonde 10, die eine Sensorelektrode 11 und eine Schirmelektrode 12 aufweist. Die beiden Elektroden 11 und 12 sind mit einer Elektronik 13 verbunden, die dazu bestimmt ist, Schaltvorgänge in Abhängigkeit von der Kapazität der Sensorelektrode 12 auszulösen. Als Beispiel wird nachfolgend angenommen, daß die Sonde 10 zur Überwachung eines vorbestimmten Füllstands in einem Behälter verwendet wird, so daß die Kapazität der Sondenelektrode 11 davon abhängt, ob die Sonde 10 vom Füllgut bedeckt ist oder nicht.

Die Elektronik 13 enthält eine Oszillator 14, der aus zwei Operationsverstärkern 15 und 16 gebildet ist. Der erste Operationsverstärker 15 ist als Differenzverstärker geschaltet; er enthält in seinem vom Ausgang zum invertierenden Eingang führenden Rückkopplungskreis einen Widerstand 17 parallel zu einem Kondensator 18. Die Sensorelektrode 11 ist an den invertierenden Eingang des ersten Operationsverstärkers 15 angeschlossen. Ferner liegt zwischen dem Ausgang des ersten Operationsverstärkers 15 und einem mit dem negativen Pol -U$_B$ der Betriebsspannung (Schaltungsnull oder Masse) verbundenen Leiter 19 ein Spannungsteiler 20, der durch die Reihenschaltung eines Widerstands 21, eines Potentiometers 22, eines Widerstands 23 und eines Widerstands 24 gebildet ist.

Der zweite Operationsverstärker 16 ist als Spannungsfolger (Impedanzwandler) geschaltet, indem sein Ausgang direkt mit seinem invertierenden Eingang verbunden ist. Der nichtinvertierende Eingang des zweiten Operationsverstärkers 16 ist an den Abgriff des Potentiometers 22 angeschlossen. Der Ausgang des zweiten Operationsverstärkers 16 ist mit dem nichtinvertierenden Eingang des ersten Operationsverstärkers 15 verbunden. An diese Verbindung ist die Schirmelektrode 12 über einen Kondensator 25 angeschlossen.

An den Ausgang des ersten Operationsverstärkers 15 ist ferner über einen Kondensator 26 und einen Widerstand 27 eine Gleichrichterschaltung 30 angeschlossen, die durch die Parallelschaltung einer Diode 31 und eines Widerstands 32 gebildet ist, von denen jeweils eine Klemme mit dem Leiter 19 und die andere Klemme mit der Basis eines Transistors 33 verbunden ist. Der Emitter des Transistors 33 ist mit dem Leiter 19 verbunden, und sein Kollektor ist über einen Widerstand 34 an den positiven Pol +U$_B$ der Betriebsspannung angeschlossen. Zwischen dem Kollektor des Transistors 33 und dem Leiter 19 ist ein integrierendes RC-Glied 35 angeschlossen, das aus einem Widerstand 36 und einem Kondensator 37 besteht. An den Ausgang 38 des integrierenden RC-Glieds ist der Eingang eines Schmitt-Triggers 39 angeschlossen.

Zwischen dem Ausgang 38 des RC-Glieds 35 und dem Leiter 19 ist ferner ein Spannungsteiler 40 angeschlossen, der aus zwei Widerständen 41 und 42 besteht. An den Abgriff 43 des Spannungsteilers 40 ist die Basis eines Transistors 44 angeschlossen, dessen Kollektor-Emitter-Strecke parallel zu dem Widerstand 24 des Spannungsteilers 20 geschaltet ist.

Die beiden Operationsverstärker 15 und 16 bilden ein rückgekoppeltes System, das als Oszillator schwingt, wenn die Wechselspannungsverstärkung V$_S$ der geschlossenen Schleife die Selbsterregungsbedingung

$$V_S > 1$$

erfüllt. Die Schleifenverstärkung V$_S$ ist gleich dem Produkt aus der Wechselspannungsverstärkung V$_1$ des ersten Operationsverstärkers 15, der Wechselspannungsverstärkung V$_2$ des zweiten Operationsverstärkers 16 und dem Teilerfaktor k des Spannungsteilers 20:

$$V_S = V_1 \cdot V_2 \cdot k$$

Nachfolgend wird die Kapazität des Kondensators 18 mit C$_{18}$ bezeichnet, und die Kapazität, die die Sensorelektrode 11 gegenüber einer auf dem Potential des Leiters 19 (Schaltungsnull oder Masse) liegenden Gegenelektrode aufweist, wird mit C$_{11}$ bezeichnet. In dem hier angenommenen Fall der Überwachung eines vorbestimmten Füllstands in einem Behälter kann die Gegenelektrode die metallische Behälterwand sein. Die Kapazität C$_{11}$ hat einen Grundwert C$_0$, wenn die Sonde 10 nicht von dem Füllgut im Behälter bedeckt ist, und sie nimmt einen größeren Wert an, wenn die Sonde 10 von dem Füllgut bedeckt wird.

Der Widerstandswert R$_{17}$ des Widerstands 17 realisiert die Gleichspannungsgegenkopplung des ersten Operationsverstärkers 15. Die Gleichspannungsverstärkung des ersten Operationsverstärkers 15 hat den Wert 1. Der Widerstand 17 wird so dimensioniert, daß gilt:

$$R_{17} \gg 1/\omega C_{18},$$

wenn $\omega$ die Kreisfrequenz $2\pi f$ der Schwingung ist, zu der sich das rückgekoppelte System erregt.

Die Kapazitäten $C_{11}$ und $C_{18}$ bestimmen die Wechselspannungsverstärkung $V_1$ des ersten Operationsverstärkers 15 wie folgt:

$$V_1 = 1 + C_{11}/C_{18}$$

Die Wechselspannungsverstärkung $V_2$ des zweiten Operationsverstärkers beträgt

$$V_2 = 1$$

Mit dem Teilerfaktor k des Spannungsteilers 20 beträgt die Wechselspannungsverstärkung $V_S$ der geschlossenen Schleife somit

$$V_S = k \cdot (1 + C_{11}/C_{18})$$

Wählt man für die Kapazität $C_{18}$ des Kondensators 18 den Grundwert $C_0$ der Sensorkapazität:

$$C_{18} = C_0$$

und für den Teilerfaktor k des Spannungsteilers 20 den Wert

$$k = 0,49$$

so hat die Schleifenverstärkung $V_S$ den Wert

$$V_S = 0,98$$

wenn die Sensorkapazität $C_{11}$ den Grundwert $C_0$ hat, also die Sonde 10 nicht von Füllgut bedeckt ist. Da somit die Selbsterregungsbedingung nicht erfüllt ist, schwingt der Oszillator 14 nicht, und am Ausgang des ersten Operationsverstärkers 15 ist keine Wechselspannung vorhanden. Demzufolge entsteht an der Basis des Transistors 33 keine Gleichspannung, und der Transistor 33 bleibt dauernd gesperrt. Daher liegt an dem mit dem Ausgang 38 des RC-Glieds 35 verbundenen Eingang des Schmitt-Triggers 39 dauernd das Potential $+U_B$ der Betriebsspannung an, und das am Ausgang des Schmitt-Triggers 39 abgegebene binäre Signal hat einen ersten Signalwert, der diesen Zustand der Sonde 10 kennzeichnet.

Bei der angegebenen Einstellung der Elektronik bewirkt bereits eine geringe Erhöhung der Kapazität $C_{11}$ der Sensorelektrode 11 infolge einer Bedeckung mit Füllgut eine Erhöhung der Schleifenverstärkung $V_S$ über den Wert 1:

$$V_S > 1$$

wodurch der Oszillator 14 zu schwingen beginnt. Dann besteht am Ausgang des ersten Operationsverstärkers 15 eine Wechselspannung, die über den Kondensator 26 und den Widerstand 27 der Gleichrichterschaltung 30 zugeführt wird. Infolge der Gleichrichterwirkung der Diode 31 entsteht am Widerstand 32 eine positive gleichgerichtete Spannung, die den Transistor 33 öffnet. Da nun über den Transistor 33 ein Kollektorstrom fließt, sinkt die am RC-Glied 35 anliegende Kollektorspannung und demzufolge auch die am Eingang des Schmitt-Triggers 39 anliegende, vom Kondensator 37 geglättete Gleichspannung um den Spannungsabfall am Widerstand 34 ab. Der Schmitt-Trigger 30 geht daher in seinen anderen Zustand, und das an seinem Ausgang abgegebene binäre Signal nimmt seinen zweiten Signalwert an, der nun anzeigt, daß die Sonde 10 vom Füllgut bedeckt ist.

Die am Ausgang 38 des Integrierglieds 35 bestehende und am Eingang des Schmitt-Triggers 39 anliegende Spannung liegt auch an dem Spannungsteiler 40 an. Wenn der Oszillator 14 nicht schwingt, ist diese Spannung hoch, so daß an die mit dem Abgriff 43 des Spannungsteilers 40 verbundene Basis des Transistors 44 eine Spannung angelegt wird, die den Transistor 44 öffnet, der demzufolge den Widerstand 24 kurzschließt. Der Teilerfaktor k des Spannungsteilers 20 wird in diesem Zustand nur durch die Widerstände 21 und 23 sowie durch die Einstellung des Potentiometers 22 bestimmt. Sobald der Oszillator 14 zu schwingen beginnt und demzufolge die Spannung am Ausgang 38 auf einen niedrigen Wert geht, reicht die am Abgriff 43 des Spannungsteilers 40 bestehende Spannung nicht mehr aus, um den Transistor 44 zu öffnen. Der Transistor 44 wird daher gesperrt, und der Widerstand 24 liegt nunmehr in Reihe mit dem Widerstand 23 im Spannungsteiler 20. Dadurch hat der Teilerfaktor k einen höheren Wert als bei kurzgeschlossenem Widerstand 24. Dies hat zur Folge, daß die Schwingungen des Oszillators 14 erst aussetzen, wenn die Kapazität $C_{11}$ der Sensorelektrode 11 auf einen Wert gefallen ist, der kleiner als der Wert ist, der den Schwingungseinsatz ausgelöst hat. Somit ergibt der Transistor 44 eine Schalthysterese, die ein stabiles Verhalten des Oszillators 14 gewährleistet, indem sie verhindert, daß die Schwingungen wiederholt ein- und aussetzen, wenn die Sensorkapazität $C_{11}$ um einen kritischen Wert schwankt.

Der Einsatzpunkt der Schwingungen des Oszillators 14, d. h. der Wert der Sensorkapazität $C_{11}$, bei dem der Oszillator 14 zu schwingen beginnt, wenn der Widerstand 24 kurzgeschlossen ist, läßt sich mit Hilfe des Potentiometers 22 genau einstellen. Diese Einstellung muß für jede Sonde 10 individuell erfolgen, um fertigungsbedingte Schwankungen und stark unterschiedliche Einbaubedingungen zu berücksichtigen. Der Teilerfaktor k des Spannungsteilers 20 muß natürlich unter Berücksichtigung der Schalthysterese so eingestellt werden, daß die Sensorkapazität $C_{11}$, bei der die Schwingungen wieder aussetzen, noch größer als die Grundkapazität $C_0$ ist, die der unbedeckten Sonde entspricht.

Die Schirmelektrode 12 ist an den nichtinvertierenden Eingang des ersten Operationsverstärkers 15 angeschlossen, dessen invertierender Eingang mit der Sensorelektrode 11 verbunden ist. Da ein Operationsverstärker die Spannungen an seinen beiden Eingängen exakt gleich zu halten sucht, liegen an den beiden Elektroden 11 und 12 Wechselspannungen an, die nach Amplitude und Phase stets genau gleich sind. Somit besteht zwischen der Sensorelektrode 11 und der Schirmelektrode 12 niemals eine Wechselpotentialdifferenz. Störgrößen, die sich auf die Kapazität der Schirmelektrode 12 auswirken, haben dadurch keinen Einfluß auf die Kapazität der Sensorelektrode 11. Da ferner der Ausgang des als Spannungsfolger geschalteten zweiten Operationsverstärkers 16, der die Spannung zur Schirmelektrode 12 liefert, sehr niederohmig ist, bildet er einen idealen Treiber für die Schirmelektrode. Durch diese Beschaltung der Schirmelektrode 12 wird eine exzellente Schirmwirkung erzielt.

Der Transistor 44 bildet einen durch das Ausgangssignal des Oszillators 14 gesteuerten Schalter. Er könnte auch durch einen anderen elektrisch steuerbaren Schalter bekannter Art ersetzt werden, der jedoch vorzugsweise ein schneller elektronischer Schalter sein sollte.

**Patentansprüche**

1. Kapazitiver Schalter mit einer kapazitiven Sonde, die eine Sensorelektrode und eine Schirmelektrode aufweist, und mit einer Elektronik, die einen durch ein rückgekoppeltes System von zwei Verstärkern gebildeten Oszillator enthält, wobei die Sensorelektrode mit einem der Verstärker so verbunden ist, daß der Schwingungseinsatz und der Schwingungsabriß des Oszillators durch Änderungen der Kapazität der Sensorelektrode bestimmt wird, und wobei die Schirmelektrode an einen Verstärkerausgang derart angeschlossen ist, daß die an der Schirmelektrode anliegende Wechselspannung nach Amplitude und Phase mit der an der Sensorelektrode anliegenden Wechselspannung übereinstimmt, dadurch gekennzeichnet, daß der Oszillator durch zwei Operationsverstärker gebildet ist, daß der erste Operationsverstärker als Differenzverstärker geschaltet ist, dessen invertierender Eingang mit der Sensorelektrode verbunden ist und dessen vom Ausgang zum invertierenden Eingang führender Rückkopplungskreis einen Kondensator parallel zu einem hochohmigen Widerstand enthält, daß der zweite Operationsverstärker als Spannungfolger geschaltet ist und an seinem nichtinvertierenden Eingang einen mittels eines einstellbaren Spannungsteilers eingestellten Teil der Ausgangsspannung des ersten Operationsverstärkers empfängt, daß der Ausgang des zweiten Operationsverstärkers mit dem nichtinvertierenden Eingang des ersten Operationsverstärkers verbunden ist, und daß die Schirmelektrode an die Verbindung zwischen dem Ausgang des zweiten Operationsverstärkers und dem nichtinvertierenden Eingang des ersten Operationsverstärkers angeschlossen ist.

2. Kapazitiver Schalter nach Anspruch 1, dadurch gekennzeichnet, daß an den Ausgang des Oszillators eine Auswerteschaltung angeschlossen ist, die ein Ausgangssignal liefert, das einen ersten Signalwert hat, wenn der Oszillator nicht schwingt, und das einen zweiten Signalwert hat, wenn der Oszillator schwingt.

3. Kapazitiver Schalter nach Anspruch 2, dadurch gekennzeichnet, daß der Spannungsteiler einen Widerstand enthält, dem ein Schalter parallelgeschaltet ist, der durch das Ausgangssignal der Auswerteschaltung so gesteuert wird, daß er den Widerstand kurzschließt, wenn der Oszillator schwingt, um durch Verringerung des Teilerfaktors des Spannungsteilers eine Schalthysterese zu erzeugen.

Europäisches
Patentamt

## EUROPÄISCHER RECHERCHENBERICHT

Nummer der Anmeldung

EP 96 11 5296

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| X | DE-U-94 14 164 (ZABEL GMBH) 17.November 1994 <br> * Seite 5, Zeile 21 - Seite 6, Zeile 21; Abbildung 1 * <br> --- | 1,2 | H03K17/955 |
| A | EP-A-0 461 550 (IFM ELECTRONIC GMBH) 18.Dezember 1991 <br> * Spalte 4, Zeile 36 - Spalte 5, Zeile 15 * <br> * Spalte 9, Zeile 9 - Zeile 39 * <br> --- | 3 | |
| A | EP-A-0 049 793 (IFM ELECTRONIC GMBH) 21.April 1982 <br> * Seite 6, Zeile 1 - Seite 7, Zeile 30; Abbildung 2 * <br> ----- | 1,2 | |

RECHERCHIERTE SACHGEBIETE (Int.Cl.6)

H03K

Der vorliegende Recherchenbericht wurde für alle Patentansprüche erstellt

| Recherchenort | Abschlußdatum der Recherche | Prüfer |
|---|---|---|
| DEN HAAG | 19.Dezember 1996 | D/L PINTA BALLE.., L |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

....................................
& : Mitglied der gleichen Patentfamilie, übereinstimmendes Dokument

EPO FORM 1503 03.82 (P04C03)